(19) Europäisches Patentamt
European Patent Office
Office européen des brevets

(11) Publication number : **0 407 384 B1**

# EUROPEAN PATENT SPECIFICATION

(45) Date of publication of patent specification : **01.02.95 Bulletin 95/05**

(51) Int. Cl.⁶ : **H01F 6/06**

(21) Application number : **88909356.3**

(22) Date of filing : **20.10.88**

(86) International application number : **PCT/GB88/00878**

(87) International publication number : **WO 89/04049 05.05.89 Gazette 89/10**

(54) **MAGNET ASSEMBLY.**

(30) Priority : **23.10.87 GB 8724824**

(43) Date of publication of application : **16.01.91 Bulletin 91/03**

(45) Publication of the grant of the patent : **01.02.95 Bulletin 95/05**

(84) Designated Contracting States : **AT BE CH DE FR GB IT LI LU NL SE**

(56) References cited : **EP-A- 0 240 935**

(73) Proprietor : **OXFORD MEDICAL LIMITED Osney Mead, Oxford, OX2 0DX (GB)**

(72) Inventor : **MCDOUGALL, Ian, Leitch 16 Lees Heights Charlbury Oxon (GB)** Inventor : **BLACK, David Bleinheim Cottage The Slade Charlbury Oxon OX7 3SJ (GB)**

(74) Representative : **Skone James, Robert Edmund et al GILL JENNINGS & EVERY Broadgate House 7 Eldon Street London EC2M 7LH (GB)**

## Description

MAGNET ASSEMBLY

The invention relates to a magnet assembly.

In our European Patent Application No.0160350 we described a low aspect ratio magnet for use in magnetic resonance imaging (MRI). This magnet assembly was configured with a minimum possible dimension in the patient access direction so that the least surface area of the patient was obscured during the course of examination. In the examples described, counter-running coils are used to reverse the sign of various low order error terms thus causing a substantially homogenous magnetic field to be generated within a uniform region in the bore of the assembly.

As well as increasing patient access, this type of magnet has other advantages. These include the use of a much smaller cryostat than has hitherto been possible, so reducing the thermal load and therefore cryogen running costs; and a reduction in the general dimensions of the assembly thus improving siting flexibility and also the potential for reducing the cost of the cryostat materials both by reducing dimensions and the weight of the assembly.

It has been found, however, that to take full advantage of the unobscured access to the uniform region, it is necessary to reduce the fringe magnetic field generated by the assembly. Of course, since the magnet assembly is short in the axial direction, there is a substantial fringe field for a given bore field.

We have considered reducing the fringe field by providing around the assembly a second set of counter-running coils but we have found that this has minimal effect on the external, axial field. A further disadvantage of this "active" shielding is that the diameter of the assembly is significantly increased and this in turn removes the benefits achieved through reducing the overall volume of the cryostat. It should be understood that the cryostat is needed in this case since in general superconducting materials are used for the coils which only achieve the superconductive condition at very low temperatures.

EP-A-0240935 describes a conventional MRI magnet having a set of coils that generate a homogeneous field within a working volume and an external iron shield.

EP-A-0167059 discloses the use of iron shims to improve the homogeneity of a magnetic field.

In accordance with the present invention, a magnet assembly comprises at least one electrical coil for generating a magnetic field in a working region; and a passive outer shield of magnetic material provided around the coil, characterized in that the passive outer shield is positioned and constructed so as to increase the homogeneity of the magnetic field within the working region and reduce the magnetic field strength externally of the assembly when working currents flow in the at least one coil relative to the homogeneity and external field strength respectively when the same working currents flow through the at least one coil alone.

We have discovered that it is possible to provide around the coil a passive shield of magnetic material (typically a ferro-magnetic material such as iron) which not only reduces the fringe field strength but also increases the homogeneity of the field within the working region.

Typically the working region will be defined within a bore of the at least one electrical coil although it could be axially offset from the coil.

In some examples, the magnet assembly comprises a number of coils which could be axially offset nested, or both. In general, however, the coils will be substantially coaxial.

In order to generate an optimum form for the shield, we have devised an analytical method in which the magnetic shield is considered not only as providing the return flux path for the fringe field but is also considered as a set of quasi-current carrying coils which contribute towards the magnetic field in the working region. This is achieved in practice by representing the iron in calculations as a set of equivalent current carrying shells. In this way it is possible to produce a coupled design where the physical coils of the magnet assembly and the surrounding shield are considered as an integral source of field energy.

We have found that where both the shield and coil(s) are simultaneously optimised, less conductor is needed for a given homogeneity than for the same dimension of magnet assembly and homogeneity in the absence of the shield. To some degree this is due to straight forward enhancement effects known previously because the energy density in the shield is higher than in free space surrounding the coils and there is a commensurate increase in bore field. However, further specific advantages of using the shield can be identified. The most important of these is that it is generally the case for a short (in the axial direction) aspect ratio magnet, that the larger coils in the absence of the shield are needed to control low order field errors. It is a consequence of placing a cylinder of magnetic material around the coils that low order field errors are produced by the shield.

Preferably, the shield overlaps the coil or coils in both the axial directions. We have found that in this case, the low order field errors produced by the shield have positive values compared with the field errors due to the coil(s) and in this situation, the larger coils of the previously unshielded assembly can be dispensed with

2

and the magnetic shield can be used to control positive low order field errors. In this situation, the possibility of yet further reductions in the length of the assembly may be economically achieved.

A further advantage of using a passive shield in this configuration is that the rotation of magnetic flux within the coil(s) from the axial to the radial direction is minimised which, in turn, reduces shear stresses in the windings and therefore coil material (typically superconductor) can be used more efficiently.

Preferably, the direction of magnetisation lies substantially parallel with the surface of the magnetic shield. This means that in the case of a cylindrical shield, that part of the shield surrounding the coil(s) has a thickness such that the principal direction of magnetisation is substantially parallel with the axis of the magnet assembly. This assists considerably in determining the form of the shield since "cross talk" between different parts of the shield is substantially eliminated. Typically, the shield is made thin by for example cutting from thin sheet. To obtain sufficient material to carry flux for shielding purposes, a number of the sheets may be combined to form a laminar structure.

The invention is particularly suited for use with magnet assemblies with low aspect ratios, for example where the axial lengh of the bore is between 0.8 and 1.4 times the bore diameter.

Two examples of magnet assemblies according to the invention will now be described with reference to the accompanying drawings, in which:-

Figure 1 is a schematic cross-section through part of a first example with the cryostat omitted for clarity;

Figure 2 is a schematic illustration of the magnetic field intensity outside the assembly of Figure 1;

Figure 3 illustrates a system for further homogenising the field of the Figure 1 assembly; and,

Figure 4 is a cross-section through part of a second example.

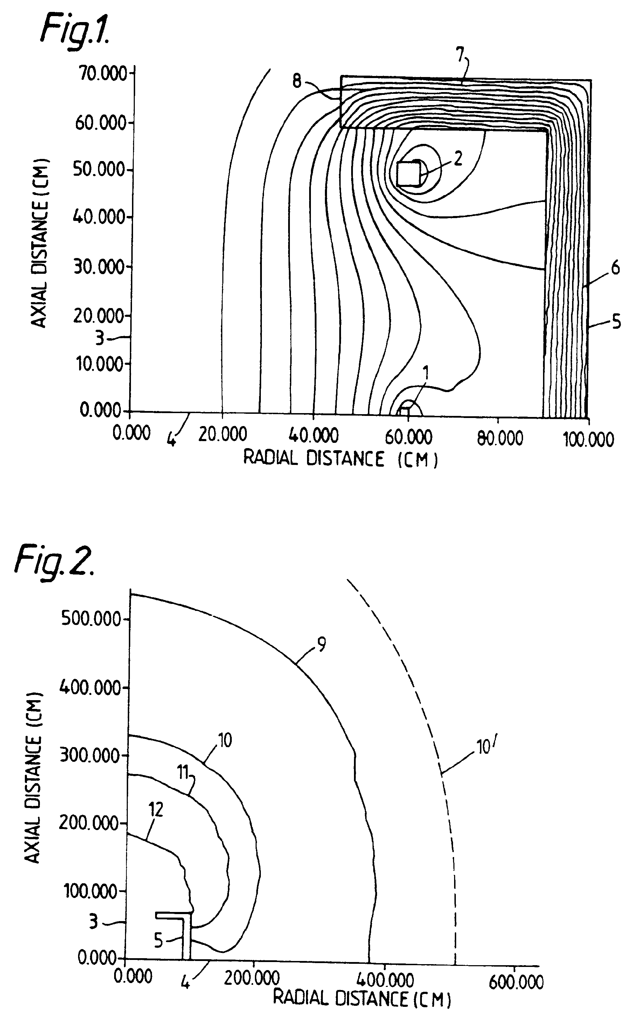

The magnet assembly shown in Figure 1 comprises three coaxial and axially spaced superconducting coils two of which 1, 2 are shown in Figure 1. The coils are provided about an axis 3 and it should be understood that the magnet assembly is symmetrical about the axis 3 and also about a mid-plane 4 orthogonal to the axis 3. Thus, the third coil corresponding to the coil 2 is positioned symmetrically with the coil 2 on the other side of the mid-plane 4. The coils are positioned in a cryostat (not shown) to reduce their temperature to that required for superconductivity.

The coil 1 has an inner radial dimension of 59cm and an outer radial dimension of the 60cm, an axial length of 5.6cm and is centred symmetrically about the mid-plane 4. The coil has 67.2 kAmp-turns and a current density of -24000 A/cm$^2$.

The coil 2 has an inner radius of 57.5cm and an outer radius of 62.5cm. Its axially inner surface is positioned 47.375cm from the mid-plane 4 and its axially outer surface 52.625cm from the mid-plane 4. The coil has 232.864 kAmp-turns with a current density of -8871A/cm$^2$. The third coil, symmetrically placed relative to the coil 2 is identical with the coil 2 and carries an identical current density.

In this example, the current in each coil runs in the same direction.

An iron shield 5 is positioned about the coils and has a cylindrical section 6 coaxial with the axis 3 of the coils and symmetrically positioned about the mid-plane 4 and a pair of disc shaped end sections 7 (only one of which is shown in Figure 1) one at each end of the cylindrical section 6. The iron shield may be made from separate components or, as shown in the drawing, can be made as a one-piece structure. The radially inner surface 8 of the disc shaped section 7 defines the width of the bore of the magnet assembly (referred to further below).

In this example, the shield has a constant thickness of 10cm, an outer axial length of 140cm and an inner axial length of 120cm. The shield is placed such that the distance from the inner face 8 of the disc shaped section 7 to the axis 3 is 45cm leading to a bore diameter of 90cm. Consequently, the inner diameter of the shield is 90cm and the outer diameter 200 cm.

Each coil generates a magnetic field which can be defined in terms of a zero order component and a number of higher order error terms. The magnitude of these error terms determines the homogeneity of the field within the magnet assembly and in MRI a high homogeneity is normally required. Generally, the coils by themselves cannot generate a sufficiently high homogeneity for this purpose. We have found that it is possible to provide an iron shield 5 of such a form that the homogeneity of the field within the magnet assembly is improved while also a degree of magnetic shielding in achieved outside the magnet assembly. In practice, the iron shield 5 is relatively thin such that the direction of principle magnetisation within the shield is substantially parallel with the axis 3 of the assembly. This enables the shield to be treated as an array which simplifies the analytical process needed to optimise the coil and shield sizes.

To determine the shield and coil sizes, we initially envisage the shield 5 as providing a return flux path for the fringe magnetic field (ie. the field outside the assembly) as well as viewing the shield as a set of quasi-current carrying coils. This is achieved in practice by representing the shield in calculations as a set of equivalent current carrying shells. In this way it is possible to produce a coupled design where the three physical coils of the magnet assembly and the surrounding iron of the shield 5 are considered as an integral source of field energy and we seek to optimise the set of arrays to produce a homogeneous bore field and a minimum external fringe field.

The presently preferred method of obtaining the optimum design is as follows:

a) We take a conventional magnet assembly and add an iron yolk shield using finite element methods to reduce the fringe field.

b) We find the field enhancement and the fringe field reduction for an arbitrarily given mass of iron.

c) We lower the amount of superconductor in the coils to reduce the bore field to the level of the unshielded magnet assembly and reexamine using finite element methods the amount of iron needed to achieve the original fringe field values. We determine the error terms arising from the iron in the bore of the magnet assembly (coils and iron) using equivalent shell modelling and the principal direction of magnetisation in the iron using finite element methods.

d) We contour the iron to compensate for low order field errors. This is achieved by using the principal direction of magnetisation derived from the finite element methods and taking this direction, calculating equivalent current shells to represent the iron in a field error expansion optimisation exercise. Such an optimisation is described in more detail in EP-A-0160350, pages 7-10.

This set of calculations can be run iteratively in which, in essence, a finite element routine defines the fringe field and the bore error terms coarsely, as well as the direction of principal magnetisation, and then, in a second step, the iron is treated as a set of quasi coils and optimised along with the real coils.

The variation in magnetic field within the bore of the magnet assembly having the coils and shields defined in detail above has been calculated and is set out in Table 1 below. The first section of Table 1 indicates the variation in terms of magnetic field strength and the second section in terms of parts per million. In each case, only axial, spherical harmonic terms have been considered on a radius from the origin of the magnet of 22.5cm.

It should be noted that the harmonic error terms quoted in Table 1 have been computed using methods well known to those skilled in the art by making use of computer algorithms based on Legendre Polynomials. This method was originally described by Garrett in J.Appl Physics, Vol. 22, No.9, September 1951, page 1091.

## TABLE 1

### Spherical Harmonics (Tesla)

| | COILS ALONE | IRON ALONE | TOTAL |
|---|---|---|---|
| $B_0$ | -0.362915 | -0.132148 | -0.495063 |
| $B_2$ | 1.435040E-03 | -2.832385E-03 | -1.397345E-03 |
| $B_4$ | -1.916816E-03 | 2.523520E-03 | 6.067041E-04 |
| $B_6$ | 1.068067E-03 | 1.109722E-04 | 1.179039E-03 |
| $B_8$ | -1.777658E-04 | -1.630155E-05 | -1.940673E-04 |
| $B_{10}$ | 2.145536E-05 | -1.592662E-06 | 1.986270E-05 |
| $B_{12}$ | -3.003423E-06 | 5.527157E-08 | -2.948151E-06 |
| $B_{14}$ | 4.900921E-07 | 1.436581E-08 | 5.044579E-07 |
| $B_{16}$ | -7.588701E-08 | 2.404750E-10 | -7.564653E-08 |
| $B_{18}$ | 1.093090E-08 | -9.379002E-11 | 1.083711E-08 |
| $B_{20}$ | -1.556705E-09 | -6.212239E-12 | -1.564917E-09 |

### CONTAMINANTS (ppm of Bo field)

| | COILS ALONE | IRON ALONE | TOTAL |
|---|---|---|---|
| $B_2$ | -2898.70 | 5721.27 | 2822.56 |
| $B_4$ | 3871.36 | -5097.38 | -1225.51 |
| $B_6$ | -2157.44 | -224.158 | -2381.60 |
| $B_8$ | 359.077 | 32.9283 | 392.006 |
| $B_{10}$ | -43.3387 | 3.21709 | -40.1216 |
| $B_{12}$ | 6.06675 | -0.111646 | 5.95511 |
| $B_{14}$ | -0.989960 | -2.901817E-02 | -1.01898 |
| $B_{16}$ | 0.153238 | -4.857467E-04 | 0.152802 |
| $B_{18}$ | -2.207983E-02 | 1.894508E-04 | -2.189038E-02 |
| $B_{20}$ | 3.148500E-03 | 1.254839E-05 | 3.161049E-03 |

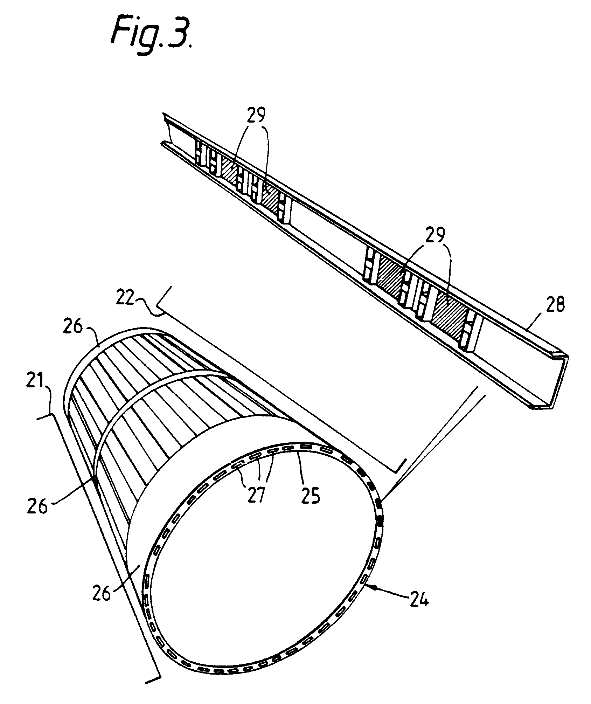

In an ideal situation, the error terms due to the iron would have an opposite sign and an equal magntiude to the error terms due to the coils and it will be seen from Table 1 that a significant approach has been achieved to this optimum condition. The example described leads to a homogeneity of ±1000ppm over a volume useful for whole body imaging ie. an axial length of 40cm and a radius of 25cm along the mid-plane 4 leading to a sphere of an average radius of about 23cm. The homogeneity can be improved still further by mounting within the bore of the magnet assembly a passive iron shimming system described in more detail in our copending International Patent Application No.PCT/GB88/00286. This is shown schematically in Figure 3 which illustrates the bore 22 of the magnet assembly as defined by the inner surface 21 of a cryostat within which the coils are mounted. In order to homogenise further the magnetic field within the bore, a field modification system 24 is slid within the bore 22. The system 24 comprises an inner cylinder 25 of a non-ferromagnetic material around the outside of which are positioned three bands 26 of non-magnetic material, spaced apart in the axial direction. The inner surface of each band 26 has a number of elongate grooves 27 spaced at about 10° intervals around the circumference of the cylinder 25. Each set of aligned grooves 27 is adapted to receive an elongate tray 28 of a non-magnetic material which can be slid through the grooves and extends along the full length of the cylinder 25 at a substantially constant radial distance from the axis of the bore 22. Each tray 28 has a number of pockets 29 positioned at predetermined locations along its length.

Into some of the pockets 29 of each tray are positioned one or more identical shim pieces constructed from laminations of a grain oriented (ie. rolled) steel. In this example, iron pieces having dimensions of 100 x 100 mm are used while the radius of the inner cylinder 25 has a radius 40cm. Table 2 below illustrates the thickness and position relative to the mid-plane 4 of the iron pieces placed in each tray 28 to further homogenise the magnetic field within the bore. In this table, the negative sign indicates that the iron piece is positioned on the opposite side to the mid-plane 4 of the iron pieces having a position with a positive sign.

### TABLE 2

| AXIAL POSITION OF POCKET RELATIVE TO MID-PLANE 4 (mm) | DEPTH OF IRON IN POCKET (mm) |
|---|---|
| -304 | 17.722 |
| -182 | 4.805 |
| -80 | 8.25 |
| 0 | 4.186 |
| 80 | 8.25 |
| 182 | 4.805 |
| 304 | 17.722 |

Corresponding pockets in each tray 28 define respective rings of iron. Table 3 below indicates the axial, spherical harmonic terms due to the iron pieces alone.

### TABLE 3

| AXIAL CONTAMINANT | PREDICTED CONTAMINANT (ppm) |
|---|---|
| $B_2$ | -2804 |
| $B_4$ | 1198.6 |
| $B_6$ | +2316 |
| $B_8$ | -454 |
| $B_{10}$ and above | 334 |

The values in the second column of Table 3 should be compared with the contaminant values in Table 1 above where it will be seen that the predicted contaminants due to the iron pieces are very nearly equal and opposite to the contaminants due to the coils and iron at least up to the tenth order.

By making use of the additional iron piece shimming arrangement, the homogeneity of the field can be reduced to the order of 300ppm on a 40cm radius sphere and 17ppm on a 30cm radius sphere centred on the origin. This is quite adequate for the purposes of MRI. In practice, the modification of the homogeneity of the bore field from ±1000ppm down to a value of some 10's of ppm will modify the flux distribution in the bore and this will interact slightly with the distribution of flux in the shield. Thus the whole system should be reexamined using the Finite Element methods and the amount of iron piece shimming adjusted until the required homogeneity is achieved.

As well as coupling with the coils to generate a substantially homogeneous field within the bore, the shield 5 also significantly reduces the fringe magnetic field.

The reason for the shielding can be seen from Figure 1 where the magnetic flux lines have been plotted and it will be seen that their return path is concentrated into the iron shield 5.

In the example described, the fringe magnetic field is shown in Figure 2 where lines 9-12 indicate the regions where the magnetic field strength is 1 Gauss, 5 Gauss, 10 Gauss and 50 Gauss respectively. It will be seen that a significant degree of shielding has been achieved with the 5 Gauss region extending no more than 200cm in the radial direction and 340cm in the axial direction. For comparison, the dashed line 10' in Figure 2 illustrates the 5 Gauss region in the absence of the shield 5. This line meets the axis 3 at about 800 cm from the centre of the assembly.

Table 4 below compares the number of amp turns required by different types of magnet assembly to generate the same bore field of 0.5T. It can be seen from this table that the Figure 1 example has a much more efficient construction and is therefore cheaper and more lightweight than either of the other constructions. In Table 4 "Magnet 1" is a conventional unshielded magnet, "Magnet 2" is an actively shielded magnet of the form illustrated in EP-A-144171 and "Magnet 3" is a magnet constructed in accordance with Figure 1 of this description.

## TABLE 4

| | Bore diameter | No of amp-turns |
|---|---|---|
| Magnet 1 | 1.0m | $1 \times 10^6$ |
| Magnet 2 | 0.85m | $3.3 \times 10^6$ |
| Magnet 3 | 0.9m | $0.6 \times 10^6$ |

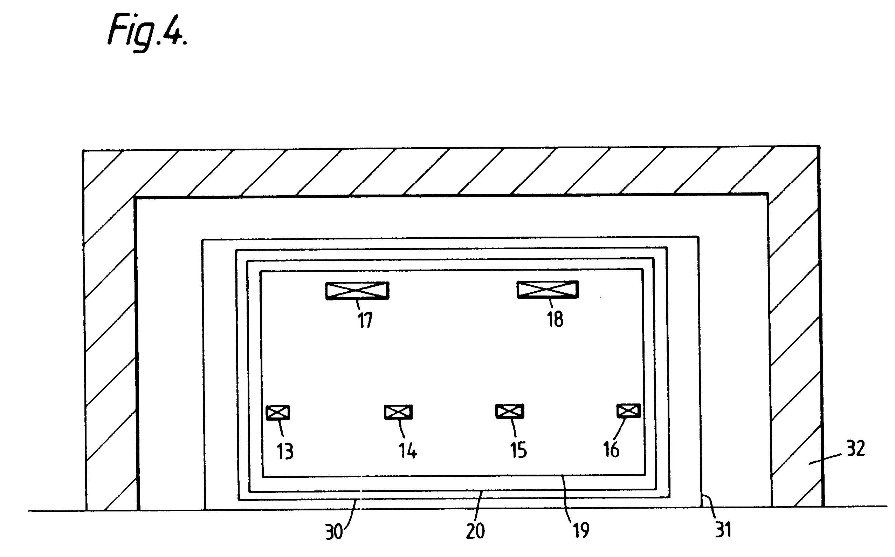

A second example of a magnet assembly is partly shown in Figure 4 which comprises an inner set of four, axially spaced coils 13-16 and an outer pair of coils 17,18 mounted coaxially with the coils 13-16. The coils 17,18 carry current which runs counter to the current carried by the coils 13-16. The coils 13-18 are made of superconductive material and are positioned within a helium vessel 19. The helium vessel 19 forms part of a cryostat which also includes an inner, radiation shield 20 surrounding the helium vessel 19, an outer radiation shield 30 surrounding the inner shield 20, and an outer vacuum chamber 31 surrounding the outer shield 30.

An iron yoke or shield 32 is mounted around the cryostat and is equivalent to the iron shield 5 in the previous example, the radially extending sections of the yoke constituting "pole pieces" which have a similar affect to the sections 7 of the first example.

In this example, the axis of the coils is not shown.

Figure 4 is schematic and does not show the exact locations of the coils 13-18 and shield 32. These can be calculated using the methods previously described.

## Claims

1. A magnet assembly comprising at least one electrical coil (1,2) for generating a magnetic field in a working region; and a passive outer shield (5) of magnetic material provided around the coil, characterized in that the passive outer shield is positioned and constructed so as to increase the homogeneity of the magnetic field within the working region and reduce the magnetic field strength externally of the assembly when working currents flow in the at least one coil relative to the homogeneity and external field strength respectively when the same working currents flow through the at least one coil alone.

2. An assembly according to claim 1, wherein the shield (5) is made of iron.

3. An assembly according to claim 1 or claim 2, wherein the magnet assembly comprises a number of coaxial, axially spaced coils positioned radially inwardly of the shield.

4. An assembly according to any of claims 1 to 3, wherein the working region is positioned within a volume defined by the or each coil.

5. An assembly according to any of claims 1 to 4, wherein at least two substantially coaxial electrical coils are provided radially inwardly of the shield, the internal radius of at least one of the coils being less than that of another of the coils.

6. An assembly according to claim 5, wherein said at least two coils (13-16; 17,18) are coupled to a power supply so as to carry respective counter-running working currents.

7. An assembly according to claim 1, wherein the shield (5) overlaps the coil or coils (1,2) in both the axial directions.

8. An assembly according to claim 7, wherein the shield (7) has radially inwardly projecting sections (7) at each axial end.

9. An assembly according to claim 1, wherein the thickness of the magnetic shield is such that the principle direction of magnetisation in the shield is substantially parallel with the axis (3) of the magnet assembly.

10. An assembly according to claim 1, further comprising passive shim means positioned within the or each coil to further homogenise the magnetic field within the working region.

11. An assembly according to any of the preceding claims, wherein the assembly has an aspect ratio in the range 0.8-1.4.

**Patentansprüche**

1. Magnetanordnung mit wenigstens einer elektrischen Spule 1, 2 zur Erzeugung eines Magnetfeldes in einem Arbeitsbereich; und eine passive äußere Abschirmung (5) aus magnetischem Material, die um die Spule angeordnet ist, **dadurch gekennzeichnet**, daß die passive äußere Abschirmung so angeordnet und gestaltet ist, daß sie die Homogenität des Magnetfeldes in dem Arbeitsbereich steigert und die magnetische Feldstärke außerhalb der Anordnung vermindert, wenn Arbeitsströme in der wenigstens einen Spule fließen, im Vergleich zu der Homogenität und der äußeren Feldstärke, wenn dieselben Arbeitsströme durch die wenigstens eine Spule allein fließen.

2. Anordnung nach Anspruch 1, bei der die Abschirmung (5) aus Eisen besteht.

3. Anordnung nach Anspruch 1 oder 2, bei der die Magnetanordnung mehrere koaxiale, axial beabstandete Spulen aufweist, die radial innerhalb der Abschirmung angeordnet sind.

4. Anordnung nach einem der Ansprüche 1 bis 3, bei der der Arbeitsbereich innerhalb eines Raumes liegt, der von der oder jeder Spule bestimmt ist.

5. Anordnung nach einem der Ansprüche 1 bis 4, bei der wenigstens zwei im wesentlichen koaxial elektrische Spulen radial innerhalb der Abschirmung angeordnet sind, wobei der Innenradius wenigstens einer der Spulen kleiner als der einer anderen der Spulen ist.

6. Anordnung nach Anspruch 5, bei der die wenigstens zwei Spulen (13 bis 16; 17, 18) mit einer Stromquelle derart verbunden sind, daß sie gegenläufige Arbeitsströme führen.

7. Anordnung nach Anspruch 1, bei der die Abschirmung (5) die Spule oder Spulen (1, 2) in beiden axialen Richtungen belappt.

8. Anordnung nach Anspruch 7, bei der die Abschirmung (7) radial nach innen vorstehende Abschnitte (7) an jedem axialen Ende aufweist.

9. Anordnung nach Anspruch 1, bei der die Dicke des Magnetfeldes derart ist, daß die Hauptrichtung der Magnetisierung in der Abschirmung im wesentlichen parallel zur Achse (3) der Magnetanordnung ist.

10. Anordnung nach Anspruch 1, weiterhin enthaltend passive Scheibeneinrichtungen, die innerhalb der oder jeder Spule angeordnet sind, um das magnetische Feld innerhalb des Arbeitsbereiches weiter zu homogenisieren.

11. Anordnung nach einem der vorhergehenden Ansprüche, bei der die Anordnung ein Schlankheitsverhältnis im Bereich von 0,8 bis 1,4 hat.

**Revendications**

1. Ensemble d'aimant comprenant au moins un bobinage électrique (1, 2) pour la génération d'un champ magnétique dans une zone de travail et un blindage externe passif (5) en un matériau magnétique prévu autour du bobinage,
   ensemble caractérisé en ce que le blindage externe passif est placé et structuré de façon à améliorer l'homogénéité du champ magnétique dans la zone de travail et à réduire l'intensité du champ magnétique à l'extérieur de l'ensemble lorsque des courants fonctionnels traversent au moins le bobinage par rapport à, respectivement, l'homogénéité et l'intensité du champ externe créés lorsque les mêmes courants traversent au moins le bobinage seul.

2. Ensemble selon la revendication 1, dans lequel le blindage (5) est en fer.

3. Ensemble selon la revendication 1 ou 2, dans lequel l'ensemble d'aimant comprend un certain nombre de bobinages coaxiaux axialement espacés et placés radialement à l'intérieur du blindage.

4. Ensemble selon l'une quelconque des revendications 1 à 3, dans lequel la zone de travail est placée dans un volume défini par le ou par chaque bobinage.

5. Ensemble selon l'une quelconque des revendications 1 à 4, dans lequel au moins deux bobinages électriques pratiquement coaxiaux sont prévus radialement à l'intérieur du blindage, le rayon interne d'au moins un des bobinages étant inférieur à celui de l'autre des bobinages.

6. Ensemble selon la revendication 5, dans lequel lesdits au moins deux bobinages (13 à 16; 17, 18) sont couplés à une alimentation de puissance de façon à transporter des courants respectifs de réaction.

7. Ensemble selon la revendication 1, dans lequel le blindage (5) recouvre le ou les bobinages (1, 2) dans chacune des directions axiales.

8. Ensemble selon la revendication 7, dans lequel le blindage (7) possède des sections se projetant radialement vers l'intérieur (7) à chaque extrémité axiale.

9. Ensemble selon la revendication 1, dans lequel l'épaisseur du blindage magnétique est telle que la direction principale de magnétisation dans le blindage est pratiquement parallèle à l'axe (3) de l'ensemble d'aimant.

10. Ensemble selon la revendication 1, comprenant, de plus, un moyen de compensation passif placé dans le ou dans chaque bobinage pour homogénéiser, de plus, le champ magnétique dans la zone de travail.

11. Ensemble selon l'une quelconque des revendications précédentes, dans lequel l'ensemble présente un rapport dimensionnel compris entre 0,8 et 1,4.

*Fig.1.*

*Fig.2.*

Fig.3.

Fig.4.